# EUROPÄISCHE PATENTANMELDUNG

(11) **EP 1 450 478 A2**
(43) Veröffentlichungstag der Anmeldung: **25.08.2004**
(21) Anmeldenummer: 04002076.0
(22) Anmeldetag: 30.01.2004
(51) Int. Cl.: H02N 2/18, H01L 41/113, F21L 13/06

(54) **Einrichtung zur Versorgung tragbarer Geräte mit elektrischer Energie**

(30) Priorität: 07.02.2003 DE 10305026
(71) Anmelder: CeramTec AG, 73207 Plochingen (DE)
(72) Erfinder: Bindig, Reiner, 95463 Bindlach (DE); Schreiner, Hans-Jürgen, Dr., 91233 Neunkirchen am Sand-Rollhofen (DE); Handschuh, Kurt, 90542 Eckental (DE); Tzschentke, Konrad, 91224 Pommelsbrunn (DE)
(74) Vertreter: Uppena, Franz, Dr.

(57) **Zusammenfassung**

Die Versorgung tragbarer Geräte mit elektrischer Energie erfolgt in der Regel durch Primärelemente, Sekundärelemente, oder mit Solarzellen. Elektrische Geräte, die durch Solarzellen mit Energie versorgt werden, sind nur dann einsatzfähig, wenn eine bestimmte Helligkeit nicht unterschritten wird. Insbesondere bei Taschenlampen erfolgt die Energieversorgung mit nicht wieder aufladbaren oder wieder aufladbaren Batterien. Bei längerer Liegezeit entladen sich die Batterien. Das führt häufig dazu, dass dann, wenn man sie gebrauchen will, die Batterien zu schwach oder gar vollständig entladen sind. Auch tiefe Temperaturen, etwa unter 10 °C, können den Einsatz herkömmlicher Batterien unmöglich machen.

Erfindungsgemäß wird deshalb vorgeschlagen, dass die Einrichtung zur Versorgung tragbarer Geräte mit elektrischer Energie mindestens einen Piezowandler (4) aufweist, der mit einer Vorrichtung (19, 22) verbunden ist, mit der er mit einer periodisch einwirkenden Druckkraft beaufschlagbar ist, dass dem Piezowandler (4) eine Gleichrichterschaltung (35) nachgeschaltet ist, in dem die durch die periodisch einwirkende Druckkraft an dem Piezowandler (4) abgreifbare periodische Spannung mit wechselndem Vorzeichen gleichgerichtet wird und dass durch den Ladungsabfluss aus dem nachgeschalteten Speicherkondensator (40), der über die Gleichrichterschaltung (35) aufladbar ist, auch in den Pausen zwischen den Einwirkungen der Druckkraft auf den mindestens einen Piezowandler (4) ein kontinuierlicher und weitgehend gleichmäßiger Stromfluss gewährleistet ist.

## Beschreibung

Die Erfindung betrifft eine Einrichtung zur Versorgung tragbarer Geräte mit elektrischer Energie.

Aus dem Stand der Technik sind tragbare Geräte bekannt, deren Versorgung mit elektrischer Energie durch Primärelemente, also nicht wieder aufladbaren Batterien, Sekundärelemente, also Akkumulatoren, oder mit Solarzellen erfolgt. Elektrische Geräte, die durch Solarzellen mit Energie versorgt werden, sind nur dann einsatzfähig, wenn eine bestimmte Helligkeit nicht unterschritten wird. Insbesondere bei Taschenlampen erfolgt die Energieversorgung mit nicht wieder aufladbaren oder wieder aufladbaren Batterien. Bei längerer Liegezeit entladen sich die Batterien. Das führt häufig dazu, dass dann, wenn man sie gebrauchen will, die Batterien zu schwach oder gar vollständig entladen sind, so dass die Geräte nicht einsatzfähig sind. Auch tiefe Temperaturen, etwa unter 10 °C, können den Einsatz herkömmlicher Batterien unmöglich machen.

Um die aufgeführten Nachteile zu vermeiden, gibt es beispielsweise Taschenlampen, die einen über einen Handhebel angetriebenen Dynamo aufweisen. Zur Überbrückung der Betätigungspausen ist ein Schwungrad vorgesehen. Ein Schwungrad muss eine entsprechende Größe und Masse besitzen, um seine vorgesehene Funktion zufriedenstellend erfüllen zu können. Dadurch wird eine Taschenlampe unhandlich und schwer. Die Lager des Schwungrads, das Übersetzungsgetriebe des Antriebs sowie die Freilaufkupplung sind geräuschverursachende Verschleißteile. Die Helligkeit und Gleichmäßigkeit des Lichts hängt direkt von der Intensität der Betätigung ab und unterliegt trotz des Schwungrads ständigen Schwankungen.

Aufgabe der Erfindung ist es, eine Einrichtung zur Versorgung tragbarer Geräte mit elektrischer Energie vorzustellen, die die oben beschriebenen Nachteile nicht aufweist.

Die Lösung der Aufgabe erfolgt mit Hilfe der kennzeichnenden Merkmale des ersten Anspruchs, vorteilhafte Ausgestaltungen der Erfindung werden in den Unteransprüchen beansprucht.

Die erfindungsgemäße Einrichtung zur Versorgung tragbarer Geräte mit elektrischer Energie besteht aus mindestens einem Piezowandler, bevorzugt ein Vielschichtelement, der mit einer Vorrichtung verbunden ist, mit der er mit einer periodischen einwirkenden Druckkraft beaufschlagbar ist. Durch die periodisch einwirkende Druckkraft ist an dem Piezowandler eine periodische Spannung mit wechselndem Vorzeichen abgreifbar, die in einer Gleichrichterschaltung gleichgerichtet wird. Der Gleichrichterschaltung ist ein Speicherkondensator nachgeschalteten, der über die Gleichrichterschaltung aufladbar ist, damit durch den Ladungsabfluss auch in den Pausen zwischen den Einwirkungen der Druckkraft auf den mindestens einen Piezowandler ein kontinuierlicher und weitgehend gleichmäßiger Stromfluss gewährleistet ist.

Die Vorteile eines Piezowandlers als Stromerzeuger liegen in seinen geringen Abmessungen und seinem geringen Gewicht. Der Aufbau der Einrichtung ist einfach und dadurch verschleißarm und unempfindlich gegen raue Behandlung.

Die erfindungsgemäße Einrichtung zur Versorgung tragbarer Geräte mit elektrischer Energie ist besonders geeignet für Anwendungen, bei denen eine zuverlässige Funktion der Geräte auch nach langen Betriebspausen oder Lagerzeiten erforderlich ist, insbesondere bei Dunkelheit oder bei sehr tiefen Temperaturen. Deshalb eignet sich die Erfindung beispielsweise vorteilhaft für Handlampen für Notbeleuchtungszwecke.

Beim Einsatz der erfindungsgemäßen Einrichtung für Beleuchtungszwecke werden Leuchtdioden als Lichtquellen verwendet. In vorteilhafter Weise wird durch sie der Strom mit gutem Wirkungsgrad in Licht umgesetzt.

Die Verbraucher können über eine Konstantstromschaltung oder über einen Abwärts-DC-DC-Wandler aus dem Speicherkondensator gespeist werden. Dadurch wird vorteilhaft eine gleichbleibende Stromversorgung gewährleistet, wodurch beispielsweise eine Lampe mit konstanter Helligkeit brennen kann.

Eine Erhöhung der elektrischen Energie kann vorteilhaft durch eine Parallelschaltung von Piezowandlern oder durch eine größere Anzahl von Schichten, also durch seine Länge, erreicht werden.

Anhand eines Ausführungsbeispiels wird die Erfindung näher erläutert. Es zeigen:
- Figur 1: eine Taschenlampe als Gerät mit der erfindungsgemäßen Einrichtung zur Versorgung mit elektrischer Energie und
- Figur 2: einen Schaltplan der Taschenlampe.

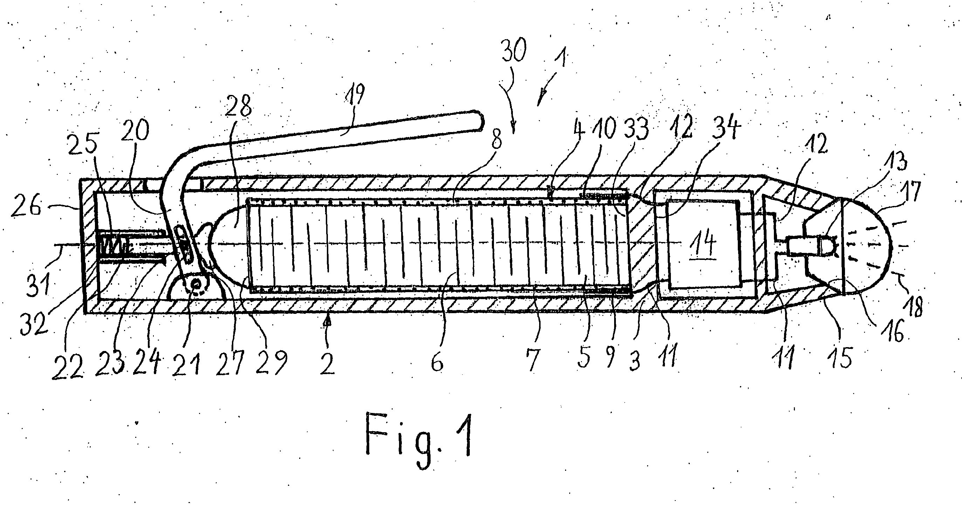

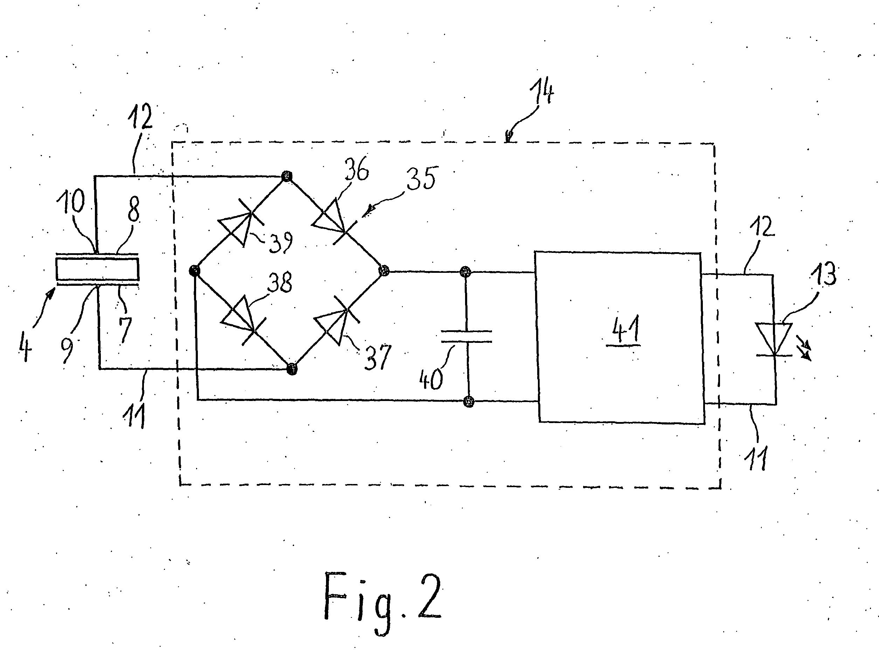

In Figur 1 ist eine Taschenlampe 1 beispielhaft als Gerät mit der erfindungsgemäßen Einrichtung 2 zur Versorgung mit elektrischer Energie dargestellt. Die Darstellung ist schematisch und soll nur den prinzipiellen Aufbau der Erfindung zeigen. In einem rohrförmigen Gehäuse 3 ist ein Piezowandler 4 untergebracht. Es ist ein Vielschichtelement, das heißt es besteht aus gestapelten dünnen Schichten 5 piezoelektrisch aktiven Werkstoffs, beispielsweise Blei-Zirkonat-Titanat, mit dazwischen angeordneten leitfähigen Innenelektroden 6. Die Innenelektroden 6 sind alternierend an die sich gegenüberliegenden Flächen des Piezowandlers 4 geführt und werden dort durch die Außenelektroden 7 beziehungsweise 8 elektrisch parallel geschaltet und so zu einer Gruppe zusammengefasst. Die Außenelektroden 7 und 8 weisen jeweils einen Anschluss 9 beziehungsweise 10 auf, von denen die Leitungen 11 beziehungsweise 12 zum Verbraucher führen. Der Verbraucher ist in diesem Fall eine Leuchtdiode 13. Zwischen dem Piezowandler 4 und der Leuchtdiode 13 ist eine elektronische Schaltung 14 zwischengeschaltet, die zur Gleichrichtung der im Piezowandler 4 erzeugten Spannung und zur Speicherung elektrischer Ladung dient. Der Aufbau der elektronischen Schaltung 14 ist in der Figur 2 dargestellt und in deren Figurenbeschreibung erläutert. Die Leuchtdiode 13 ist in dem konischen Ende 15 der Taschenlampe 1 angeordnet. Sie ist von einem Reflektor 16 umgeben und wird von einer Linse 17 zur Bündelung der von der Leuchtdiode 13 abgegebenen Strahlung 18 abgedeckt.

Die elektrische Energie wird durch Betätigung eines Hebels 19 erzeugt, der aus dem Gehäuse 3 herausragt. Je nach Größe der Taschenlampe kann dieser handbetätigte Hebel 19 auch als Clip zum Einhängen in eine Tasche oder einen Gürtel genutzt werden. Der Handhebel 19 ist L-förmig gebogen und sein kurzer Schenkel 20 ist mit seinem Ende in einem Gelenkpunkt 21 an der Innenseite des Gehäuses 3 gelagert. Der kurze Schenkel 20 des Handhebels 19 ist mit einem Stößel 22 über einen Splint 23 verbunden, der in einem Langloch 24 in dem kurzen Schenkel 20 geführt wird. Der Stößel 22 wird wiederum in einem Rohr 25 geführt, das mittig auf dem Boden 26 des Gehäuses 3 angeordnet ist. Der verbreiterte Kopf 27 des Stößels 22 stützt sich auf eine Halbkugel 28, die auf die den Anschlüssen 9 und 10 abgewandte Stirnseite 29 des Piezowandlers 4 aufgesetzt ist. Dadurch ist gewährleistet, dass beim Betätigen des Handhebels 19 in Betätigungsrichtung 30 die durch den Stößel 22 auf den Piezowandler 4 ausgeübte Kraft in Richtung seiner Mittellinie 31 eingeleitet und er nicht auf Biegung beansprucht wird. Eine schwache Feder 32 sorgt dafür, dass der Stößel 22 immer an dem Piezowandler 4 anliegt. Das Ende 33 des Piezowandlers 4, an dem die Anschlüsse 9 und 10 der Außenelektroden 7 beziehungsweise 8 angeordnet sind, stützt sich auf eine Zwischenwand 34 im Gehäuse 3.

Wird der Handhebel 19 periodisch in Betätigungsrichtung 30 betätigt, wird der Piezowandler 4 periodisch mit einer Druckkraft beaufschlagt, was zu einer periodischen Spannung mit wechselndem Vorzeichen an den beiden Anschlüssen 9 und 10 führt, die über die Leitungen 11 und 12 auch an der elektronischen Schaltung 14 anliegt, in der sie gleichgerichtet und geglättet wird.

Ein Beispiel für den Aufbau der elektronischen Schaltung 14 ist in der Figur 2 dargestellt. Vom Piezowandler 4 fließt ein Wechselstrom über die Leitungen 11 und 12 in eine Gleichrichterschaltung 35, die durch vier Gleichrichter-Dioden 36, 37, 38 und 39 gebildet wird. Über die Gleichrichterschaltung 35 wird ein Speicherkondensator 40 aufgeladen, durch dessen Entladungen jeweils die Betätigungspausen am Piezowandler 4 überbrückt werden. Um einen gleichmäßigen Stromfluss und damit eine gleichmäßige Helligkeit zu gewährleisten, fließ der Strom über eine Konstantstromschaltung oder einen Abwärts-DC-DC-Wandler 41 zur Leuchtdiode 13.

Die erfindungsgemäße Einrichtung ließe sich durch hier nicht dargestellte und beschriebene konstruktive Varianten auch für andere Zwecke einsetzen, beispielsweise an Stelle eines Fahrrad-Dynamos. Eine durch einen Radreifen angetriebene Nockenwelle könnte dann den Hebel 19 betätigen. Die Taschenlampe könnte auch einen zweiten, parallelgeschalteten Piezowandler aufweisen, dessen Betätigungsvorrichtung gegenüber der des ersten Piezowandlers um 180 Grad gedreht angeordnet ist, so dass sich die zwei Handhebel gegenüberliegen und beim Schließen der Hand gleichzeitig betätigt werden.

Zur Erhöhung der Energieausbeute können auch zwei oder mehr Piezowandler parallelgeschaltet werden, die gleichzeitig mit einer periodisch einwirkenden Druckkraft beaufschlagbar sind. Technisch durchführbar ist das beispielsweise dadurch, dass den Vorrichtungen, mit denen der oder die Piezowandler mit einer periodisch einwirkenden Druckkraft beaufschlagbar sind, eine rotierende Welle mit einem Nocken zur Betätigung zugeordnet ist, wobei der Antrieb der Welle beispielsweise durch eine Handkurbel oder einen Radreifen eines Fahrrads erfolgen kann.

Soll der Stromfluss vergleichmäßigt werden, ist es vorteilhaft, wenn die zwei oder mehr parallel angeordneten Piezowandler nacheinander mit einer periodisch einwirkenden Druckkraft beaufschlagbar sind. Dafür kann beispielsweise eine rotierende Welle vorgesehen sein, auf der die Nocken so angeordnet sind, dass die Piezowandler gleichzeitig mit einer periodisch einwirkenden Druckkraft beaufschlagt werden.

## Patentansprüche

1. Einrichtung zur Versorgung tragbarer Geräte mit elektrischer Energie, **dadurch gekennzeichnet, dass** sie mindestens einen Piezowandler (4), bevorzugt ein Vielschichtelement, aufweist, der mit einer Vorrichtung (19, 22) verbunden ist, mit der er mit einer periodisch einwirkenden Druckkraft beaufschlagbar ist, dass dem Piezowandler (4) eine Gleichrichterschaltung (35) nachgeschaltet ist, in dem die durch die periodisch einwirkende Druckkraft an dem Piezowandler (4) abgreifbare periodische Spannung mit wechselndem Vorzeichen gleichgerichtet wird, dass der Gleichrichterschaltung (35) ein Speicherkondensator (40) nachgeschalteten ist, der über die Gleichrichterschaltung (35) aufladbar ist und dass durch den Ladungsabfluss aus dem Kondensator (40) über eine Konstantstromschaltung oder über einen Abwärts-DC-DC-Wandler (41) auch in den Pausen zwischen den Einwirkungen der Druckkraft auf den mindestens einen Piezowandler (4) ein kontinuierlicher und weitgehend gleichmäßiger Stromfluss gewährleistet ist.

2. Einrichtung nach Anspruch 1, **dadurch gekennzeichnet, dass** die Vorrichtung zur Erzeugung der Druckkraft auf den Piezowandler (4) der Einrichtung (2) einen Hebel (19) aufweist, dass der Hebel (19) so angeordnet ist, dass beim Schwenken um seinen Gelenkpunkt (21) mittelbar oder unmittelbar eine Beaufschlagung der Stirnseite (29) des Piezowandlers (4) mit einer Druckkraft erfolgt.

3. Einrichtung nach Anspruch 1 oder 2, **dadurch gekennzeichnet, dass** mindestens zwei Piezowandler parallel geschaltet sind.

4. Einrichtung nach Anspruch 3, **dadurch gekennzeichnet, dass** die Piezowandler gleichzeitig mit einer periodisch einwirkenden Druckkraft beaufschlagbar sind.

5. Einrichtung nach Anspruch 3, **dadurch gekennzeichnet, dass** die Piezowandler nacheinander mit einer periodisch einwirkenden Druckkraft beaufschlagbar sind.

6. Einrichtung nach einem der Ansprüche 1 bis 5, **dadurch gekennzeichnet, dass** den Vorrichtungen (19, 22), mit denen der oder die Piezowandler (4) mit einer periodisch einwirkenden Druckkraft beaufschlagbar sind, eine rotierende Welle mit einem Nocken zur Betätigung zugeordnet ist.

7. Einrichtung nach Anspruch 6, **dadurch gekennzeichnet, dass** auf der rotierenden Welle die Nocken so angeordnet sind, dass die Piezowandler gleichzeitig mit einer periodisch einwirkenden Druckkraft beaufschlagbar sind.

8. Einrichtung nach einem der Ansprüche 6 oder 7, **dadurch gekennzeichnet, dass** die rotierende Welle zur Betätigung der Einrichtung (2) durch einen Radreifen angetrieben wird.

9. Einrichtung nach einem der Ansprüche 1 bis 4, **dadurch gekennzeichnet, dass** die Einrichtung (2) in einer Lampe (1) eingebaut ist.

10. Einrichtung nach Anspruch 9, **dadurch gekennzeichnet, dass** das Leuchtmittel der Lampe (1) eine oder mehrere Leuchtdioden (13) sind.
